(19) **Europäisches Patentamt European Patent Office Office européen des brevets**

(11) **EP 3 066 694 B1**

(12) **EUROPEAN PATENT SPECIFICATION**

(45) Date of publication and mention
of the grant of the patent:
**14.10.2020 Bulletin 2020/42**

(51) Int Cl.:
*H01L 31/0224* (2006.01)  *H01L 31/0232* (2014.01)
*B82Y 30/00* (2011.01)  *G02B 6/122* (2006.01)
*H01L 31/0256* (2006.01)

(21) Application number: **14860362.4**

(22) Date of filing: **29.01.2014**

(86) International application number:
**PCT/FI2014/050071**

(87) International publication number:
**WO 2015/067843 (14.05.2015 Gazette 2015/19)**

(54) **A PHOTODETECTION APPARATUS**

**EINE VORRICHTUNG ZUR PHOTODETEKTION**

**APPAREIL DE PHOTODÉTECTION**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.11.2013 GR 20130100631**

(43) Date of publication of application:
**14.09.2016 Bulletin 2016/37**

(73) Proprietor: **Nokia Technologies Oy
02610 Espoo (FI)**

(72) Inventors:
• **ECHTERMEYER, Tim
Cambridge CB4 3HF (GB)**
• **LIDORIKIS, Elefterios
GR-45500 Ioannina (GR)**
• **COLLI, Alan
Cambridge CB4 3LT (GB)**
• **KIVIOJA, Jani
Girton CB3 0GJ (GB)**
• **FERRARI, Andrea
FI-02150 Espoo (FI)**

(74) Representative: **Sayer, Robert David et al
Venner Shipley LLP
200 Aldersgate
London EC1A 4HD (GB)**

(56) References cited:
EP-A1- 1 737 047    WO-A1-2013/074542
US-A1- 2007 235 635    US-A1- 2013 234 006

EP 3 066 694 B1

## Description

### TECHNOLOGICAL FIELD

Embodiments of the present invention relate to an apparatus to detect incident photons.

### BACKGROUND

A photo-detector is an apparatus that has a measurable electrical characteristic that changes with incidence of photons. For example, a photo-detector may transduce a photon flux into an electrical current or voltage. Photo-detectors may use semiconductors. When an incident photon is absorbed, one or more electrons are raised to a higher energy level where they produce a photocurrent. The documents EP1737047, WO2013074542 and US20070235635 disclose known examples of photodetectors involving plasmonic structures.

### BRIEF SUMMARY

The photodetection apparatus of the invention is defined in claim 1. According to various, but not necessarily all, embodiments of the invention there is provided an apparatus comprising: graphene; and an asymmetric electrode arrangement comprising a first electrode, a second electrode separated from the first electrode across a portion of the graphene and at least one surface plasmon polariton generator associated with at least the first electrode.

### BRIEF DESCRIPTION

For a better understanding of various examples that are useful for understanding the brief description, reference will now be made by way of example only to the accompanying drawings in which:

Fig 1 illustrates an example of the apparatus;
Fig 2 illustrates another example of the apparatus;
Fig 3 illustrates another example of the apparatus;
Figs 4A to 4C illustrate examples of plasmon polariton generators;
Fig 5 illustrates wave vector matching of an incident photon and a surface plasmon;
Fig 6 illustrates another example of the apparatus;
Fig 7 illustrates another example of the apparatus;
Fig 8 illustrates an example of an asymmetric first electrode;
Fig 9 illustrates a narrowband photo detector comprising the apparatus;
Fig 10 illustrates an analyte sensor comprising the apparatus; and
Fig 11 illustrates a method.

### DETAILED DESCRIPTION

The Figures illustrate an apparatus 100 comprising semiconductor 2 and an asymmetric electrode arrangement 10 comprising a first electrode 11, a second electrode 12 separated from the first electrode across a portion of the semiconductor 2 and at least one surface plasmon polariton generator 20 associated with the first electrode 11.

In the following description various examples of the apparatus 100 are described, where the semiconductor 2 is graphene. However, the semiconductor 2 may, in other examples, be a different semiconductor.

The semiconductor is a two-dimensional (2) semiconductor such as graphene or molybdenum disulphide ($MoS_2$)

In some but not necessarily all examples, the semiconductor 2 may have a low photon absorption. In some but not necessarily all examples, the semiconductor 2 may have a high electron mobility. Thus in some but not necessarily all examples, the semiconductor 2 may have an electron mobility greater than 5k $cm^2V^{-1}s^{-1}$ and a photon absorption of less than 5% or 10%.

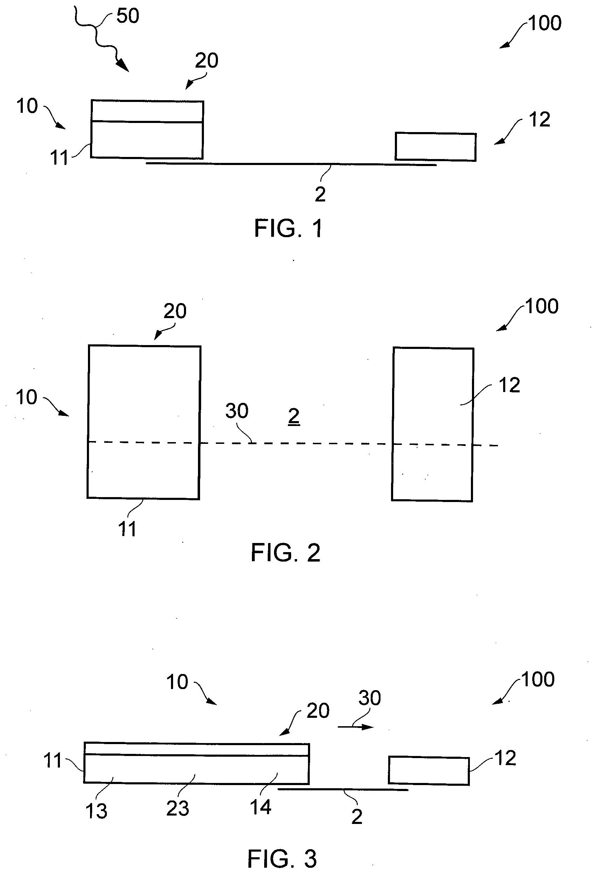

Fig 1 illustrates an example of an apparatus 100 in cross-section. The apparatus 100, in this example, is an optoelectronic apparatus that has electrical characteristics that vary in the presence of photons 50.

The apparatus 100 comprises graphene 2 and an asymmetric electrode arrangement 10 comprising a first electrode 11, a second electrode 12 separated from the first electrode across a portion of the graphene 2 and at least one surface plasmon polariton generator 20 associated with the first electrode 11.

The surface plasmon polariton generator 20 couples incident photons 50 to surface plasmons associated with the first electrode 11. The photon-surface plasmon interaction propagates as a surface plasmon polariton to the graphene 2 where decoupling of the polariton and interaction of the photon and graphene occurs.

The asymmetric electrode arrangement 10 results in a net change in the electrical characteristics of the graphene 2, which may be detected via the first electrode 11 and the second electrode 12.

Fig 2 illustrates an example of an apparatus 100 in plan view from above. The apparatus 100 may be similar to the apparatus 100 described previously with reference to Fig 1 and similar references are used to denote similar features. The description of those features in relation to Fig 1 is also applicable to the features in Fig 2.

In Fig 2, a virtual line 30 is illustrated that extends through the first electrode 11, the portion of graphene 2 between the first electrode 11 and the second electrode 12.

The surface plasmon polariton generator 20 is configured to generate surface plasmon polaritons and to transport the generated surface plasmon polaritons to the graphene 2.

In order to transport the generated surface plasmon polaritons to the graphene 2, the surface plasmon polariton generator is configured to provide a continuous plasma over at least several micrometers in a direction along the virtual line 30 through the first electrode 11, the graphene 2 and the second electrode 12. Continuous conductive material such as metal may be used to provide a continuous plasma.

Fig 3 illustrates an example of an apparatus 100 in side view. The apparatus 100 may be similar to the apparatus 100 described previously with reference to Figs 1 and/or Fig 2. Similar references are used to denote similar features. The description of those features in relation to Fig 1 and Fig 2 is also applicable to the features in Fig 3.

In Fig 3, the plasmon polariton generator 20 is configured to generate surface plasmon polaritons and to transport the generated surface plasmon polaritons from a first area 13 to a second area 14.

The first area 13 is part of the first electrode 11. It does not overlie exposed graphene 2. In some but not necessarily all examples, the first area 13 is not in physical or direct electrical contact with the graphene 2. It does not overlie the graphene 2.

The second area 14 is part of the first electrode 11. The second area 14 is in direct electrical contact with the graphene 2 and may be in physical contact. It overlies the graphene 2.

In this example, the plasmon polariton generator 20 may be configured to generate a continuous plasma form the first area 13 to the second area 14 in a direction parallel to the line 30 through the first electrode 11, the graphene 2 and the second electrode 12. The distance between the first area 13 and the second area 14 may, in some examples, be over several micrometers. Continuous conductive material 23 such as metal may be used to provide a continuous plasma.

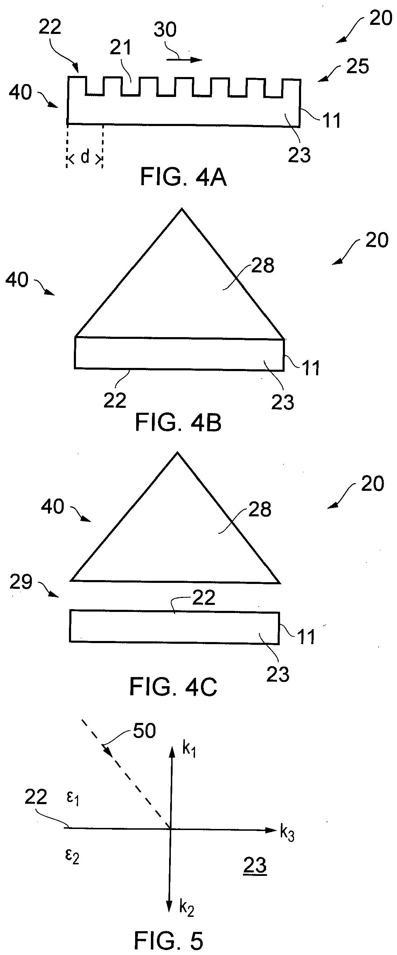

Figs 4A to 4C illustrate examples of plasmon polariton generators 20. In these examples, the plasmon polariton generators 20 comprise optical couplers 40 in combination with continuous conductive material 23. The continuous conductive material 23 is part of the first electrode 11.

A conductive path is provided along a continuous surface 22 of the first electrode 11. The conductive path may extend, as illustrated in Fig 3, from the first area 13 to the second area 14.

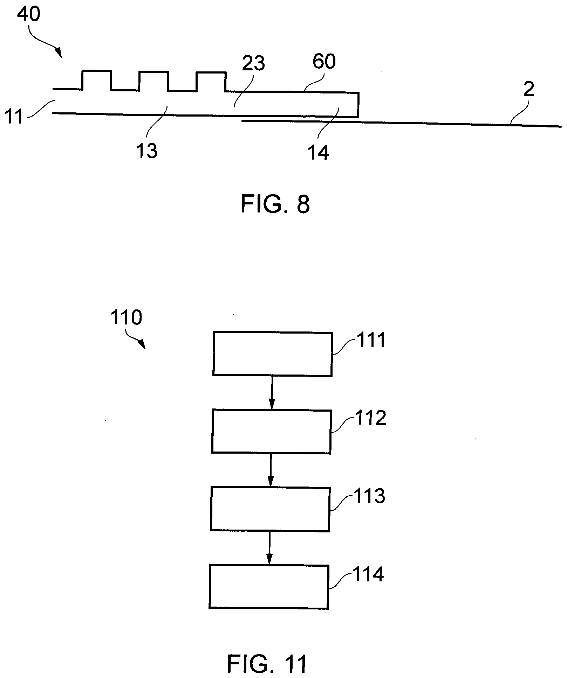

As illustrated in Fig 8, the optical coupler 40 may be associated with the first area 13 but not with the second area 14.

In the example of Fig 4A, the optical coupler 40 comprises a surface structure 25 that has periodicity in a direction parallel to the line 30.

The surface structure 25 has a repeat pattern of period d nm. The surface structure 25, in this example, is a nanoscale structure and d < 1 $\mu$m. The surface structure 25 is continuous on a scale significantly larger than its period d and it may extend for at least several $\mu$m.

The surface structure 25 may be formed by a periodic pattern, for example, undulations or channels 21, in an upper surface 22 of the conductive material 23 of the first electrode 11.

In the illustrated example, the upper surface 22 of the conductive material 23 of the first electrode 11 has periodic profile modulations 21.

The periodicity of the surface structure 25 is at least in a direction parallel to the line 30 through the first electrode 11, the graphene 2 and the second electrode 12.

In the illustrated example, the surface structure 25 is a grating. It comprises alternate high and low profile portions. In this example, the grating 25 is a regular grating and all the high portions are of the same size and all of the low portions are of the same size. The high portions and low portions may be of the same size.

The boundaries of the high and low profile portions are parallel to each other and extend orthogonally to the line 30. The repetition of the periodic surface structure 25, the periodicity, is in this example parallel to the line 30.

In the examples of Fig 4B and 4C, the optical coupler 40 comprises a prism 28. In Fig 4B, the prism 28 contacts the conductive material 23 of the first electrode 11. In Fig 4C, the prism 28 is separated from the conductive material 23 of the first electrode 11 by a very small gap 29.

As illustrated in Fig 5, a surface plasmon polariton generator 20 couples incident photons 50 with surface plasmons. This is achieved by matching the wave vector of the incident photon 50 to the wave vector of the surface plasmon.

In the simple example of Fig 5 a wave vector is represented as two components (a, b), where a is the component parallel to an interface defined by the surface 22 of the conductive material 23 and b is the component orthogonal to that interface.

If we assume that the conductive material 23 has a dielectric constant $\varepsilon_2$, and that the dielectric material (e.g. air) adjacent to the interface has dielectric constant $\varepsilon_1$, then the boundary conditions for coupling of the surface plasmon polariton and the incident photon are:

$$k_1/\varepsilon_1 + k_2/\varepsilon_2 = 0$$

$$k_3^2 + k_1^2 = \varepsilon_1 (\omega/c)^2$$

$$k_3^2 + k_2^2 = \varepsilon_2 (\omega/c)^2$$

where the incident photon has wave vector $(k_3, -k_1)$, the surface plasmon polariton has wave vector $(k_3, k_2)$, $\omega$ is the frequency of the incident photon and c is the speed of light.

The surface plasmon polariton generator 20 is configured to enable wave vector matching between the incident photon 50 and the surface plasmon. The surface plasmon polariton generator 20 is configured to impart a component of momentum (wave vector) to an incident photon 50 in at least a direction parallel to the line 30 through the first electrode 11, the graphene 2 and the second electrode 12 (i.e. parallel to the interface).

Referring back to the example illustrated in Fig 3. In this example, asymmetry between the first electrode 11 and the second electrode 12 is achieved by associating a surface plasmon polariton generator 20 with the first electrode but not associating a surface plasmon polariton generator 20 with the second electrode 12.

However, asymmetry in the asymmetrical electrode arrangement 10 may be achieved in other ways.

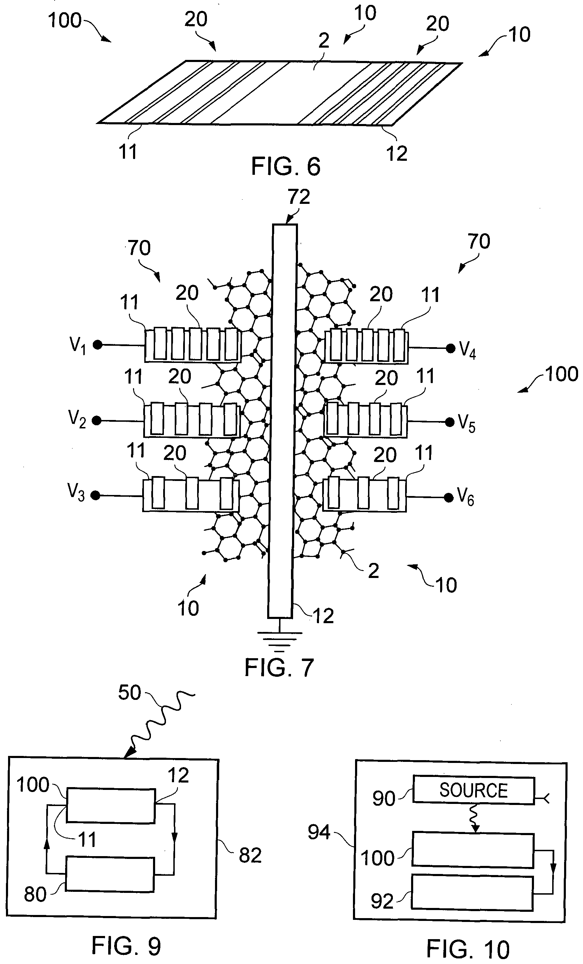

For example, as illustrated in Fig 6, the first electrode 11 may be associated with a first surface plasmon polariton generator 20 and the second electrode 12 may be associated with a second different surface plasmon polariton generator 20.

For example, the first surface plasmon polariton generator 20 may be configured to selectively couple photons of a first frequency and the second surface plasmon polariton generator 20 may be configured to selectively couple photons of a second frequency. In the illustrated example, this is achieved by using gratings 25 of different periods for the first surface plasmon polariton generator 20 and the second surface plasmon polariton generator 20.

Fig 7 illustrates an example of an apparatus 100 where the asymmetric electrode arrangement 10 comprises a plurality 70 of first electrodes 11, each of which is associated with a different surface plasmon polariton generator 20. The different surface plasmon polariton generators 20 may be configured to selectively couple photons of different particular frequencies. In the illustrated example, this is achieved by using gratings 25 of different periods for each of the first surface plasmon polariton generators 20.

In the example of Fig 7 , the second electrode 12 is a common electrode 72 separated from the plurality of first electrodes 11 by the graphene 2.

Fig 8 illustrates an example of an asymmetric first electrode 11. The first electrode comprises a first portion 13 and a second portion 14. The first portion 13 provides the optical coupler 40 in the form of a periodic grating 25 which operates as the surface plasmon polariton generator 20 as described with reference to Fig 4A. The second portion 14 does not provide a periodic grating 25. It is flat. It operates to transport generated surface plasmon polaritons to the graphene 2. In this example, the second portion 14 is adjacent to the graphene 2 and the first portion 13 is not.

The upper surface 60 of the second portion 14 may, in some examples, operate as a substrate for the adsorption of analyte.

Fig 9 illustrates a narrowband photo detector 82. The apparatus 100 is used to detect a photon 50 of a particular frequency or photons 50 of particular frequencies depending upon implementation.

A detector 80 is connected to the or each first electrode 11 and the second electrode 12 of the apparatus 100 and detects changes in the electrical characteristics of the graphene 2. For example, the graphene may produce a photo-current dependent upon the number of incident photons 50 of the correct frequency at the surface plasmon polariton generator 20 associated with the or each first electrode 11. The 'correct' frequency is determined by the boundary conditions described with reference to Fig 5.

Fig 10 illustrates an analyte sensor 94.

The apparatus 100 detects a photon 50 of a particular frequency or photons of particular frequencies depending upon implementation.

A detector 80 is connected to the or each first electrode 11 and the second electrode 12 of the apparatus 100 and detects changes in the electrical characteristics of the graphene 2. For example, the graphene may produce a photo-current dependent upon the number of incident photons 50 of the correct frequency at the surface plasmon polariton generator 20 associated with the or each first electrode 11. The 'correct' frequency is determined by the boundary conditions described with reference to Fig 5.

The analyte sensor 94 additionally comprises a source 90 of photons 50 at the correct frequency. The source 90 may be a narrowband source such as a laser or alternatively a light emitting diode.

When an analyte adsorbs to the exposed graphene 2 and/or the first electrode 11 adjacent to the graphene 2, there may be a change in how the electrical characteristics of the graphene 2 change with incident photons. The change in electrical characteristics may be calibrated against type and/or concentration of analyte.

Fig 11 illustrates a method 110 comprising:

at block 111 providing an asymmetric electrode arrangement 10 comprising a first electrode 11 and a second electrode 12 separated from the first electrode across a portion of the graphene 2,

at block 112 providing an optical coupler 40 at at least a first area 13 of the first electrode 11;

at block 113 providing a conductive path along a surface of the first electrode 11 adjacent to a dielectric from the first area 13 of the first electrode to a second area 14 of the first electrode 11 that contacts the graphene 2;

at block 114 detecting electrical characteristics of the graphene 2 using the first electrode 11 and the second electrode 12.

It will be appreciated from the described examples, that the apparatus 10 may comprise: graphene 2; and an asymmetric electrode arrangement 10 comprising a first electrode 11, a second electrode 12 separated from the first electrode 11 across a portion of the graphene 2, wherein the first electrode 11 extends from a first area 13 that does not contact the graphene to a second area 14 that does contact the graphene, and wherein the first electrode 11 at the first area 13 is associated with an optical coupler 40. The optical coupler 40 may be configured to couple photons to surface plasmons to generate surface plasmon polaritons that are transported from the first area 13 to the second area 14.

As used here 'module' refers to a unit or apparatus that excludes certain parts/components that would be added by an end manufacturer or a user. The apparatus 100 may be a module.

The term 'comprise' is used in this document with an inclusive not an exclusive meaning. That is any reference to X comprising Y indicates that X may comprise only one Y or may comprise more than one Y. If it is intended to use 'comprise' with an exclusive meaning then it will be made clear in the context by referring to "comprising only one" or by using "consisting".

In this brief description, reference has been made to various examples. The description of features or functions in relation to an example indicates that those features or functions are present in that example. The use of the term 'example' or 'for example' or 'may' in the text denotes, whether explicitly stated or not, that such features or functions are present in at least the described example, whether described as an example or not, and that they can be, but are not necessarily, present in some of or all other examples. Thus 'example', 'for example' or 'may' refers to a particular instance in a class of examples. A property of the instance can be a property of only that instance or a property of the class or a property of a sub-class of the class that includes some but not all of the instances in the class.

Although embodiments of the present invention have been described in the preceding paragraphs with reference to various examples, it should be appreciated that modifications to the examples given can be made without departing from the scope of the invention as claimed.

Semiconductor in this document includes bandgap semiconductors, which have a bandgap, and non-band gap semiconductors, which do not have a bandgap. Non-bandgap semiconductors include semimetals. In some but not necessarily all of the preceding examples, the semiconductor may be a bandgap semiconductor. In some but not necessarily all of the preceding examples, the semiconductor may be a non-bandgap semiconductor.

The semiconductor material is a material with a low density of electron states near the Fermi level, so that the amount of free carriers is too low to screen the collection field generated by the junction at the plasmon polariton generator.

Features described in the preceding description may be used in combinations other than the combinations explicitly described.

Although functions have been described with reference to certain features, those functions may be performable by other features whether described or not.

Although features have been described with reference to certain embodiments, those features may also be present in other embodiments whether described or not.

Whilst endeavoring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.

## Claims

1. A photodetection apparatus (100) comprising:

   a two-dimensional semiconductor (2), and
   an asymmetric electrode arrangement (10) comprising a first electrode (11), a second electrode (12) separated from the first electrode (11) across a portion of the two-dimensional semiconductor (2) and at least one surface plasmon polariton generator (20) associated with at least the first electrode (11).

2. A photodetection apparatus as claimed in claim 1, wherein the surface plasmon polariton generator is configured to impart a component of momentum to an incident photon in at least a direction parallel to the line through the first electrode, the two-dimensional semiconductor portion and the second electrode.

3. A photodetection apparatus as claimed in claim 2, wherein the surface plasmon polariton generator is configured to impart a component of momentum to an incident photon preferentially in the direction parallel to the line through the first electrode, the two-dimensional semiconductor portion and the second electrode.

4. A photodetection apparatus as claimed in any preceding claim, wherein the surface plasmon polariton generator is configured to generate surface plasmon polaritons and to transport the generated surface plasmon polaritons to the two-dimensional semiconductor.

5. A photodetection apparatus as claimed in any preceding claim, wherein the surface plasmon polariton generator is configured to provide a continuous plasma over at least several micrometers in a direction along the line through the first electrode, the two-dimensional semiconductor portion and the second electrode.

6. A photodetection apparatus as claimed in any preceding claim, wherein the surface plasmon polariton generator is configured to provide a continuous plasma from an area that is not contacting the two-dimensional semiconductor to an area that is contacting the two-dimensional semiconductor.

7. A photodetection apparatus as claimed in any preceding claim, wherein the surface plasmon polariton generator is configured to provide continuous metal from an area that does not contact the two-dimensional semiconductor to an area that does contact the two-dimensional semiconductor.

8. A photodetection apparatus as claimed in any preceding claim, wherein the surface plasmon polariton generator comprises a periodic structure having a periodicity, wherein the periodicity is at least in a direction parallel to the line through the first electrode, the two-dimensional semiconductor portion and the second electrode.

9. A photodetection apparatus as claimed in any preceding claim, wherein the surface plasmon polariton generator comprises a periodic structure having a periodicity, wherein the periodicity is parallel to the line through the first electrode, the two-dimensional semiconductor portion and the second electrode.

10. A photodetection apparatus as claimed in any preceding claim, wherein the two-dimensional semiconductor is graphene or molybdenum disulphide.

11. A photodetection apparatus as claimed in any preceding claim, wherein surface plasmon polariton generator comprises conductive material comprising a surface, wherein the surface is continuous and comprises periodic profile modulations.

12. A photodetection apparatus as claimed in any preceding claim, wherein the first electrode is associated with a surface plasmon polariton generator but the second electrode is not associated with a surface plasmon polariton generator.

13. A photodetection apparatus as claimed in any of claims 1 to 11, wherein the first electrode is associated with a surface plasmon polariton generator for selectively coupling photons of a first frequency and the second electrode is associated with a surface plasmon polariton generator for selectively coupling photons of a second frequency, different to the first frequency.

14. A photodetection apparatus as claimed in any preceding claim, wherein the asymmetric electrode arrangement comprises a plurality of first electrodes, each of which is associated with a surface plasmon polariton generator for selectively coupling photons of a particular frequency.

15. A photodetection apparatus as claimed in claim 14, wherein the second electrode is a common electrode separated from the plurality of first electrodes by the two-dimensional semiconductor.

**Patentansprüche**

1. Vorrichtung zur Photodetektion (100), umfassend:

einen zweidimensionalen Halbleiter (2), und eine asymmetrische Elektrodenanordnung (10) umfassend eine erste Elektrode (11), eine zweite Elektrode (12), die über einen Abschnitt des zweidimensionalen Halbleiters (2) von der ersten Elektrode (11) getrennt ist, und zumindest einen Oberflächenplasmon-Polaritongenerator (20), der zumindest mit der ersten Elektrode (11) verbunden ist.

2. Vorrichtung zur Photodetektion nach Anspruch 1, wobei der Oberflächenplasmon-Polariton-Generator so konfiguriert ist, dass er einem einfallenden Photon eine Impulskomponente in zumindest einer Richtung parallel zur Linie durch die erste Elektrode, den zweidimensionalen Halbleiterabschnitt und die zweite Elektrode verleiht.

3. Vorrichtung zur Photodetektion nach Anspruch 2, wobei der Oberflächenplasmon-Polaritongenerator so konfiguriert ist, dass er einem einfallenden Photon eine Impulskomponente vorzugsweise in der Richtung parallel zur Linie durch die erste Elektrode, den zweidimensionalen Halbleiterabschnitt und die zweite Elektrode verleiht.

4. Vorrichtung zur Photodetektion nach einem beliebigen der vorstehenden Ansprüche, wobei der Oberflächenplasmon-Polaritongenerator so konfiguriert ist, dass er Oberflächenplasmon-Polaritonen erzeugt und die erzeugten Oberflächenplasmon-Polaritonen zum zweidimensionalen Halbleiter transportiert.

5. Vorrichtung zur Photodetektion nach einem beliebigen der vorstehenden Ansprüche, wobei der Oberflächenplasmon-Polaritongenerator so konfiguriert ist, dass er ein kontinuierliches Plasma über zumindest mehrere Mikrometer in einer Richtung entlang der Linie durch die erste Elektrode, den zweidimensionalen Halbleiterabschnitt und die zweite Elektrode bereitstellt.

**6.** Vorrichtung zur Photodetektion nach einem beliebigen der vorstehenden Ansprüche, wobei der Oberflächenplasmon-Polaritongenerator so konfiguriert ist, dass er ein kontinuierliches Plasma von einem Bereich, der den zweidimensionalen Halbleiter nicht berührt, bis zu einem Bereich, der den zweidimensionalen Halbleiter berührt, bereitstellt.

**7.** Vorrichtung zur Photodetektion nach einem beliebigen der vorstehenden Ansprüche, wobei der Oberflächenplasmon-Polaritongenerator so konfiguriert ist, dass er kontinuierlich Metall von einem Bereich, der den zweidimensionalen Halbleiter nicht berührt, bis zu einem Bereich, der den zweidimensionalen Halbleiter berührt, bereitstellt.

**8.** Vorrichtung zur Photodetektion nach einem beliebigen der vorstehenden Ansprüche, wobei der Oberflächenplasmon-Polaritongenerator eine periodische Struktur mit einer Periodizität aufweist, wobei die Periodizität zumindest in einer Richtung parallel zur Linie durch die erste Elektrode, den zweidimensionalen Halbleiterabschnitt und die zweite Elektrode verläuft.

**9.** Vorrichtung zur Photodetektion nach einem beliebigen der vorstehenden Ansprüche, wobei der Oberflächenplasmon-Polaritongenerator eine periodische Struktur mit einer Periodizität aufweist, wobei die Periodizität parallel zur Linie durch die erste Elektrode, den zweidimensionalen Halbleiterabschnitt und die zweite Elektrode verläuft.

**10.** Vorrichtung zur Photodetektion nach einem beliebigen der vorstehenden Ansprüche, wobei der zweidimensionale Halbleiter ist Graphen oder Molybdändisulfid ist.

**11.** Vorrichtung zur Photodetektion nach einem beliebigen der vorstehenden Ansprüche, wobei der Oberflächenplasmon-Polaritongenerator ein leitendes Material umfasst, das eine Oberfläche aufweist, wobei die Oberfläche kontinuierlich ist und periodische Profilmodulationen umfasst.

**12.** Vorrichtung zur Photodetektion nach einem beliebigen der vorstehenden Ansprüche, wobei die erste Elektrode mit einem Oberflächenplasmon-Polaritongenerator verbunden ist, aber die zweite Elektrode nicht mit einem Oberflächenplasmon-Polaritongenerator verbunden ist.

**13.** Vorrichtung zur Photodetektion nach einem beliebigen der vorstehenden Ansprüche 1 bis 11, wobei die erste Elektrode mit einem Oberflächenplasmon-Polaritongenerator zum selektiven Koppeln von Photonen einer ersten Frequenz verbunden ist, und die zweite Elektrode mit einem Oberflächenplasmon-Polaritongenerator zum selektiven Koppeln von Photonen einer zweiten von der ersten Frequenz verschiedenen Frequenz verbunden ist.

**14.** Vorrichtung zur Photodetektion nach einem beliebigen der vorstehenden Ansprüche, wobei die asymmetrische Elektrodenanordnung eine Mehrzahl von ersten Elektroden umfasst, von denen jede mit einem Oberflächenplasmon-Polaritongenerator zur selektiven Kopplung von Photonen einer bestimmten Frequenz verbunden ist.

**15.** Vorrichtung zur Photodetektion nach Anspruch 14, wobei die zweite Elektrode eine gemeinsame Elektrode ist, die von der Mehrzahl von ersten Elektroden durch den zweidimensionalen Halbleiter getrennt ist.

**Revendications**

**1.** Appareil de photodétection (100) qui comprend :

un semi-conducteur (2) bidimensionnel et un agencement d'électrodes asymétriques (10) qui comprend une première électrode (11), une seconde électrode (12) séparée de la première électrode (11) à travers une partie du semi-conducteur (2) bidimensionnel et au moins un générateur de plasmons polaritons de surface (20) associé à la au moins une première électrode (11).

**2.** Appareil de photodétection selon la revendication 1, dans lequel le générateur de plasmons polaritons de surface est configuré pour conférer une composante de quantité de mouvement à un photon incident dans au moins une direction parallèle à la ligne à travers la première électrode, la partie de semi-conducteur bidimensionnel et la seconde électrode.

**3.** Appareil de photodétection selon la revendication 2, dans lequel le générateur de plasmons polaritons de surface est configuré pour conférer une composante de quantité de mouvement à un photon incident de préférence dans la direction parallèle à la ligne à travers la première électrode, la partie de semi-conducteur bidimensionnel et la seconde électrode.

**4.** Appareil de photodétection selon l'une quelconque des revendications précédentes, dans lequel le générateur de plasmons polaritons de surface est configuré pour produire des plasmons polaritons de surface et pour transporter les plasmons polaritons de surface produits vers le semi-conducteur bidimensionnel.

**5.** Appareil de photodétection selon l'une quelconque des revendications précédentes, dans lequel le générateur de plasmons polaritons de surface est configuré pour fournir un plasma continu sur au moins plusieurs micromètres dans une direction le long de la ligne à travers la première électrode, la partie de semi-conducteur bidimensionnel et la seconde électrode.

6. Appareil de photodétection selon l'une quelconque des revendications précédentes, dans lequel le générateur de plasmons polaritons de surface est configuré pour fournir un plasma continu depuis une zone qui n'est pas en contact avec le semi-conducteur bidimensionnel vers une zone qui est en contact avec le semi-conducteur bidimensionnel.

7. Appareil de photodétection selon l'une quelconque des revendications précédentes, dans lequel le générateur de plasmons polaritons de surface est configuré pour fournir un métal continu depuis une zone qui n'est pas en contact avec le semi-conducteur bidimensionnel vers une zone qui est en contact avec le semi-conducteur bidimensionnel.

8. Appareil de photodétection selon l'une quelconque des revendications précédentes, dans lequel le générateur de plasmons polaritons de surface comprend une structure périodique qui présente une périodicité, dans lequel la périodicité se trouve au moins dans une direction parallèle à la ligne à travers la première électrode, la partie de semi-conducteur bidimensionnel et la seconde électrode.

9. Appareil de photodétection selon l'une quelconque des revendications précédentes, dans lequel le générateur de plasmons polaritons de surface comprend une structure périodique qui présente une périodicité, dans lequel la périodicité est parallèle à la ligne à travers la première électrode, la partie de semi-conducteur bidimensionnel et la seconde électrode.

10. Appareil de photodétection selon l'une quelconque des revendications précédentes, dans lequel le semi-conducteur bidimensionnel est un graphène de disulfure de molybdène.

11. Appareil de photodétection selon l'une quelconque des revendications précédentes, dans lequel le générateur de plasmons polaritons de surface comprend un matériau conducteur qui comprend une surface, dans lequel la surface est continue et comprend des modulations de profil périodique.

12. Appareil de photodétection selon l'une quelconque des revendications précédentes, dans lequel la première électrode est associée à un générateur de plasmons polaritons de surface mais la seconde électrode n'est pas associée à un générateur de plasmons polaritons de surface.

13. Appareil de photodétection selon l'une quelconque des revendications 1 à 11, dans lequel la première électrode est associée à un générateur de plasmons polaritons de surface pour sélectivement coupler des photons d'une première fréquence et la seconde électrode est associée à un générateur de plasmons polaritons de surface pour sélectivement coupler des photons d'une seconde fréquence, différente de la première fréquence.

14. Appareil de photodétection selon l'une quelconque des revendications précédentes, dans lequel l'agencement d'électrodes asymétriques comprend une pluralité de premières électrodes, où chacune d'entre elles est associée à un générateur de plasmons polaritons de surface pour sélectivement coupler des photons d'une fréquence particulière.

15. Appareil de photodétection selon la revendication 14, dans lequel la seconde électrode est une électrode commune séparée de la pluralité de premières électrodes par le semi-conducteur bidimensionnel.

50

100

20

10

11

2

**FIG. 1**

20

100

10

30   2

12

11

**FIG. 2**

10

20   30

11

100

12

13   23   14   2

**FIG. 3**

FIG. 4A

FIG. 4B

FIG. 4C

FIG. 5

100

20    10    20    10

2

11    12

FIG. 6

72

70    70

11   20    20    11

$V_1$    $V_4$

11   20    20   11

$V_2$    $V_5$

11   20    20   11

$V_3$    $V_6$

100

10    2    10

10

12

FIG. 7

50

100    12

11

80    82

FIG. 9

90    SOURCE

94

100

92

FIG. 10

40

23  60

11

2

13  14

FIG. 8

110

111

112

113

114

FIG. 11

**EP 3 066 694 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1737047 A
- WO 2013074542 A
- US 20070235635 A